(19) **Europäisches Patentamt**

**European Patent Office**

**Office européen des brevets**

(11) **EP 1 039 643 A1**

(12) **DEMANDE DE BREVET EUROPEEN**

(43) Date de publication:
27.09.2000 Bulletin 2000/39

(51) Int. Cl.⁷: **H03M 1/10**
// H03M1/36

(21) Numéro de dépôt: **00200944.7**

(22) Date de dépôt: **15.03.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **23.03.1999 FR 9903598**

(71) Demandeur:
**Koninklijke Philips Electronics N.V.**
**5621 BA  Eindhoven (NL)**

(72) Inventeurs:
• **Thies, William**
**75008 Paris (FR)**
• **Marie, Hervé**
**75008 Paris (FR)**

(74) Mandataire: **Chaffraix, Jean**
**Société Civile S.P.I.D.**
**156, Boulevard Haussmann**
**75008 Paris (FR)**

(54) **Dispositif de conversion analogique/numérique à non-linearite différentielle constante**

(57)     La présente invention concerne un dispositif de conversion d'un signal d'entrée analogique Vin en un signal de sortie numérique OUT, dont le gain est égal au rapport entre les valeurs des signaux de sortie et d'entrée, comprenant :

.   une échelle de résistances LAD destinée à générer des tensions de référence, et
.   une pluralité d'amplificateurs A, destinés à comparer le signal d'entrée Vin avec les tensions de référence.

Selon l'invention, le dispositif de conversion est muni de moyens de réglage pour rendre le gain des amplificateurs et le gain du dispositif de conversion proportionnels entre eux L'invention permet de d'assurer que la non-linéarité différentielle du dispositif de conversion reste constante, et donc que son comportement ne change pas lorsque son gain varie.

Application : Conversion analogique/numérique de tous types de signaux électroniques.

FIG.1

**Description**

La présente invention concerne un dispositif de conversion destiné à convertir un signal d'entrée analogique en un signal de sortie numérique, présentant un gain défini comme étant égal au rapport entre les valeurs des signaux de sortie et d'entrée, dispositif comprenant:

. une échelle de résistances, disposées en série entre deux bornes d'alimentation, destinée à générer des tensions de référence,

. une pluralité d'amplificateurs, chacun étant destiné à délivrer un signal de sortie résultant de l'amplification d'une différence entre le signal d'entrée analogique et l'une des tensions de référence,

. un étage de détection destiné à signaler des passages par zéro de chacun des signaux de sortie desdits amplificateurs, et

. un encodeur binaire destiné à délivrer le signal de sortie, dont la valeur dépend desdits passages par zéro.

De tels dispositifs sont connus de l'article 〈〈An 8-bit Video ADC Incorporating Folding and Interpolation Techniques〉〉, de Mm. Van de Grift, Rutten et van der Veen, paru dans le IEEE Journal of Solid-State Circuits, vol. sc-22, No. 6. en Décembre 1987.

Ces dispositifs de conversion présentent une caractéristique de transfert, décrivant l'évolution de la valeur du signal de sortie numérique en fonction de celle du signal d'entrée analogique, qui prend la forme d'un escalier. Dans un dispositif de conversion idéal, chaque palier de l'escalier présente un point milieu dont l'abscisse correspond à la valeur de l'une des tensions de référencé, chaque point milieu pouvant être relié à tous les autres par une même droite. On dit ainsi que la caractéristique de transfert d'un dispositif de conversion idéal est linéaire. Dans les dispositifs de conversion réels, des écarts peuvent se produire par rapport à cette linéarité. On utilise fréquemment, pour modéliser le comportement des dispositifs de conversion connus et caractériser lesdits écarts, un paramètre appelé 〈〈non-linéarité différentielle〉〉, défini comme étant égal à l'écart par rapport à l'unité, représentée par le bit le moins significatif du signal de sortie numérique, que présente la différence entre les résultats de deux conversions successives au cours desquelles la tension d'entrée analogique aura pris la valeur de deux tensions de référence successives.

Un dispositif de conversion idéal présente donc en tout point de sa caractéristique de transfert une non-linéarité différentielle égale à zéro. Si, dans un dispositif de conversion réel, la caractéristique de transfert présente en un point une non-linéarité différentielle différente de zéro, ladite caractéristique présentera un code manquant, symptomatique d'une erreur de conversion.

Le gain des dispositifs de conversion décrits ci-dessus peut être exprimé sous la forme du rapport entre la valeur maximale du signal de sortie du dispositif de conversion et la valeur de la tension présente aux bornes de l'échelle de résistances. Ce gain peut être amené à varier, selon les conditions d'utilisation du dispositif de conversion. En effet, il est de pratique courante de faire correspondre la valeur maximale du signal de sortie numérique à la valeur maximale que peut prendre le signal d'entrée analogique, de manière à exploiter pleinement la gamme de valeurs disponibles pour le signal de sortie, ce qui conduit à une résolution optimale de la conversion opérée par le dispositif.

Il a été constaté que la non-linéarité différentielle dépend du gain du dispositif de conversion. Ceci implique que ce paramètre est appelé à varier en fonction des conditions d'utilisation du dispositif de conversion, ce qui implique que son comportement n'et pas prédictible. Une telle incertitude n'est pas acceptable.

La présente invention a pour but de remédier à cet inconvénient en proposant un dispositif de conversion dont la non-linéarité différentielle est constante.

Des études menées par la demanderesse ont en effet permis de démontrer que la non-linéarité différentielle, notée DNL, peut être exprimée sous la forme: DNL=VDET.GADC/GA, où VDET est une tension de décalage introduite par l'étage de détection, GADC est le gain du dispositif de conversion et GA le gain des amplificateurs.

La présente invention propose un dispositif de conversion conforme au paragraphe introductif, caractérisé en ce qu'il est muni de moyens de réglage pour rendre le gain des amplificateurs et le gain du dispositif de conversion proportionnels entre eux.

Dans un tel dispositif de conversion, la non-linéarité différentielle est proportionnelle à la tension de décalage VDET introduite par l'étage de détection. Cette tension de décalage étant fixe et intrinsèque à la structure de l'étage de détection, la non-linéarité différentielle est constante et le comportement du dispositif de conversion est prédictible, quelles que soient ses conditions d'utilisation. De plus, en optimisant la conception de l'étage de détection, il est possible de réduire à un minimum la valeur de cette tension de décalage. Dans le dispositif de conversion conforme à l'invention, cette réduction est répercutée sur la valeur de la non-linéarité différentielle, ce qui réduit à leur minimum les risques pour que des erreurs de conversion ne se produisent.

Dans un mode de réalisation particulier de l'invention, un dispositif de conversion tel que décrit plus haut est caractérisé en ce que :

. les moyens de réglage comprennent une première source de courant, disposée en série avec l'échelle de résistances, et destinée à débiter un courant dont la valeur est proportionnelle à la valeur d'un signal de contrôle, et en ce que

. chaque amplificateur est muni d'une entrée de réglage, destinée à recevoir le signal de contrôle, le gain de chaque amplificateur étant proportionnel à la valeur du signal reçu sur son entrée de réglage.

Ce mode de réalisation est avantageux en ce qu'il permet de modifier aisément le gain du dispositif de conversion et d'ajuster simultanément le gain des amplificateurs, de sorte que ces gains restent proportionnels entre eux. Les amplificateurs peuvent être réalisés sous diverses formes, comme par exemple sous la forme de cellules de Gilbert, chacune destinée à opérer une multiplication de la différence entre le signal d'entrée et l'une des tensions de référence avec le signal de contrôle.

Un mode de réalisation particulièrement avantageux du fait de sa simplicité présente un dispositif de conversion tel que décrit ci-dessus, caractérisé en ce que les amplificateurs sont constitués par des paires différentielles, toutes polarisées au moyen de sources de courants identiques entre elles, chacune étant destinée à débiter un courant dont la valeur est proportionnelle à la valeur du signal de contrôle.

Dans ce mode de réalisation, le signal de contrôle agit sur des éléments de même nature, en l'occurrence des sources de courant. Le signal de contrôle peut donc être exploité au sein des amplificateurs sans subir de transformation particulière. A contrario, l'utilisation, pour construire les amplificateurs, de cellules de Gilbert, ou plus généralement de multiplicateurs de tension, nécessitera une conversion en une tension analogique du signal de contrôle.

Dans un mode de réalisation préféré de l'invention, un dispositif de conversion tel que décrit ci-dessus est caractérisé en ce que les moyens de réglage comprennent en outre un comparateur destiné à opérer, lorsque le signal d'entrée prend une valeur dite de calibration, une comparaison entre la valeur du signal de sortie et une valeur prédéterminée, et à délivrer le signal de contrôle, dont la valeur dépend du résultat de ladite comparaison.

Cette structure des moyens de réglage permet d'ajuster aisément la valeur numérique maximale du signal de sortie à la valeur maximale du signal d'entrée analogique, représentée par le signal de calibration, et permet donc d'obtenir une résolution optimale pour la conversion réalisée par le dispositif, dont le comportement demeure prédictible grâce à l'invention.

L'invention sera mieux comprise à l'aide de la description suivante, faite à titre d'exemple non-limitatif et en regard des dessins annexés, dans lesquels :

- la figure 1 est un schéma fonctionnel décrivant un dispositif de conversion conforme à un mode de réalisation préféré de l'invention,
- la figure 2 est un graphique décrivant la caractéristique de transfert d'un dispositif de conversion,
- la figure 3 est un schéma électrique partiel décrivant un des amplificateurs inclus dans un dispositif de conversion conforme à un mode de réalisation particulier de l'invention, et
- la figure 4 est un schéma électrique décrivant une source de courant incluse dans un dispositif de conversion conforme à un mode de réalisation particulier de l'invention.

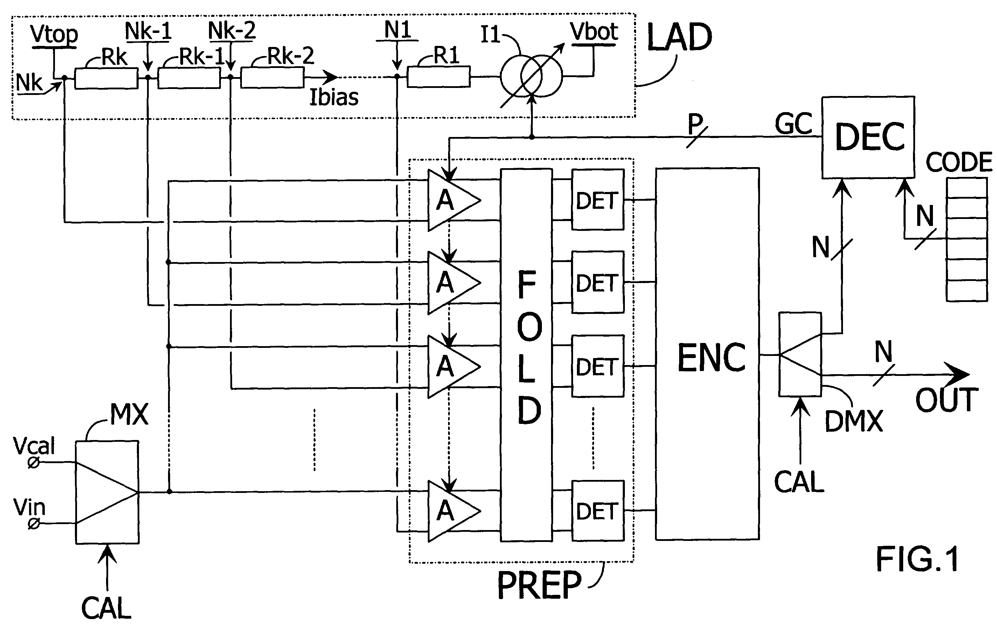

La figure 1 représente schématiquement un dispositif de conversion conforme à un mode de réalisation préféré de l'invention, destiné à convertir un signal d'entrée analogique Vin en un signal de sortie numérique OUT, codé sur N bits. Ce dispositif comprend une échelle LAD de k résistances (R1...Rk), disposées en série entre deux bornes d'alimentation Vtop et Vbot, destinée à générer des tensions de référence (V1...Vk) prélevées à des noeuds intermédiaires (N1...Nk) formés par les bornes des résistances (R1...Rk).

Dans ce mode de réalisation de l'invention, le dispositif de conversion comprend un étage de pré-traitement PREP du signal d'entrée analogique Vin, qui inclut :

. une pluralité d'amplificateurs A, chacun étant destiné à délivrer un signal de sortie résultant de l'amplification d'une différence entre le signal d'entrée analogique Vin et l'une des tensions de référence (V1...Vk), et

. un étage de détection, comportant une pluralité de bascules mémoire DET, et destiné à signaler des passages par zéro de chacun des signaux de sortie desdits amplificateurs A.

L'étage de pré-traitement PREP décrit ici comporte en outre, inséré entre les amplificateurs A et l'étage de détection DET, un étage de repliement FOLD, qui est destiné à combiner les signaux de sortie des amplificateurs A selon une technique bien connue de l'homme du métier et notamment décrite dans l'article auquel il a été fait référence plus haut.

Le dispositif de conversion comprend enfin un encodeur binaire ENC destiné à délivrer le signal de sortie OUT, dont la valeur dépend des passages par zéro des signaux de sortie des amplificateurs A détectés par l'étage de détection et identifiés par le contenu des bascules mémoire DET.

Le dispositif de conversion est muni de moyens de réglage pour rendre le gain, noté GA, des amplificateurs A et le gain du dispositif de conversion, noté GADC, proportionnels entre eux. Ces moyens de réglage comprennent une première source de courant I1, disposée en série avec l'échelle de résistances (R1...Rk), et destinée à débiter un courant Ibias dont la valeur est proportionnelle à la valeur d'un signal de contrôle GC. Chaque amplificateur A est muni d'une entrée de réglage, destinée à recevoir le signal de contrôle GC, le gain de chaque amplificateur A étant proportionnel à la valeur du signal reçu sur son entrée de réglage. Dans ce mode de réalisation préféré de l'invention, les moyens de réglage comprennent en outre un comparateur DEC destiné à opérer, lorsque le signal d'entrée prend une valeur dite de calibration, une comparaison entre la valeur du signal de sortie OUT et une valeur prédéterminée CODE, et à délivrer le signal de contrôle GC, dont la valeur dépend du résultat de ladite comparaison.

Cette structure des moyens de réglage permet d'ajuster aisément la valeur du gain GADC du dispositif de conversion, tout en maintenant constante la non-linéarité différentielle. Afin d'exploiter pleinement la gamme de valeurs disponibles du signal de sortie OUT, on choisira de préférence pour valeur prédéterminée CODE la valeur numérique maximale du signal de sortie, et pour valeur de calibration la valeur maximale que peut prendre le signal d'entrée analogique Vin. Un tel choix permet d'obtenir une résolution optimale pour la conversion réalisée par le dispositif. Dans ce mode de réalisation préféré de l'invention, le réglage du gain GADC du dispositif de conversion est effectué comme suit: lors d'une phase de calibration, un signal CAL devient actif et commande à un multiplexeur MX de substituer au signal d'entrée analogique Vin un signal de calibration Vcal ayant une valeur constante égale à la valeur de calibration. Chaque amplificateur A amplifie une différence entre ce signal de calibration Vcal et l'une des tensions de référence (V1...Vk) générées aux noeuds (N1...Nk) de l'échelle de résistances LAD. Des passages par zéro des signaux de sortie des amplificateurs A sont détectés par l'étage de détection. Le module de pré-traitement PREP effectue donc en quelque sorte une comparaison du signal de calibration Vcal avec chacune des tensions de référence (V1...Vk). Le résultat de cette comparaison est encodé par l'encodeur binaire ENC qui délivre le signal de sortie OUT, codé sur N bits, du dispositif de conversion. Pendant la phase de calibration, le signal CAL commande à un démultiplexeur DMX d'acheminer le résultat de la conversion du signal de calibration Vcal vers un comparateur DEC, qui compare ledit résultat à une valeur prédéterminée CODE préalablement mémorisée dans un registre numérique. Si, par exemple, le résultat de la conversion est inférieur à la valeur prédéterminée CODE, cela signifie que la valeur maximale que peut prendre le signal d'entrée analogique Vin est inférieure à la plus grande des tensions de référence, en l'occurrence Vk, et que les codes les plus grands ne sont pas utilisés, c'est-à-dire que la résolution de la conversion peut être améliorée. Le comparateur DEC délivre alors un signal GC dont la valeur est telle qu'elle commande une diminution du courant Ibias délivré par la première source de courant I1, qui aura pour effet de diminuer les valeurs des tensions de référence (V1...Vk) par application de la loi d'Ohm. Cette diminution se poursuivra jusqu'à ce que le résultat de la conversion du signal de calibration Vcal soit égal à la valeur prédéterminée CODE, ce qui équivaut à dire que la valeur de calibration est alors égale, dans l'exemple décrit ici, à la valeur de la plus grande des tensions de référence Vk, ce qui permet d'obtenir une résolution optimale pour la conversion.

La non-linéarité différentielle d'un dispositif de conversion connu dépend du gain GADC du dispositif, qui peut s'exprimer sous la forme $GADC=(2^N-1)/(Vtop-Vbot)$, ou encore $GADC=(2^N-1)/Vk$. Le réglage du gain décrit ci-dessus a donc pour effet de modifier de façon difficilement prédictible le comportement du dispositif connu. Le fait que, dans le dispositif de conversion conforme à l'invention, chaque amplificateur A est muni d'une entrée de réglage, destinée à recevoir le signal de contrôle GC, et que le gain GA de chaque amplificateur A est proportionnel à la valeur du signal reçu sur son entrée de réglage, permet d'assurer que la non-linéarité différentielle du dispositif reste constante, quel que soit le réglage du gain effectué, et que le comportement du dispositif de conversion demeure prédictible, puisque la non-linéarité différentielle, notée DNL, est égale à VDET.GADC/GA, où VDET est une tension de décalage introduite par l'étage de détection.

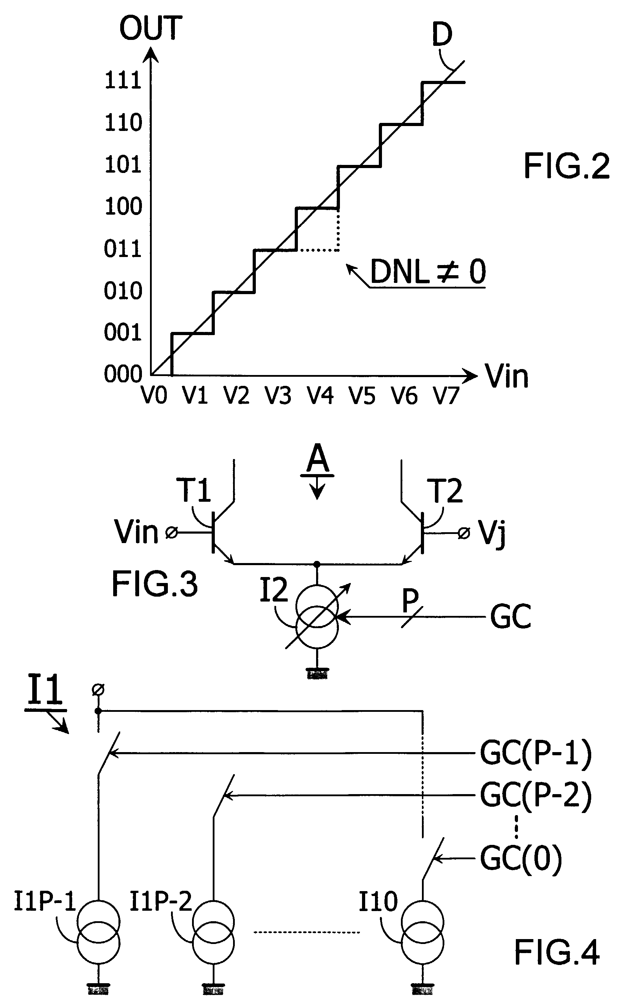

La figure 2 est une caractéristique de transfert qui décrit l'évolution de la valeur du signal de sortie numérique OUT en fonction de celle du signal d'entrée analogique Vin, qui prend la forme d'un escalier. Dans le but de simplifier la figure, le signal OUT est ici choisi comme étant codé sur 3 bits (N=3). Dans un dispositif de conversion idéal, chaque palier de l'escalier présente un point milieu dont l'abscisse correspond à la valeur de l'une des tensions de référence Vj, (pour j=0 à 7), au nombre de huit dans cet exemple, les tensions V1 à V7 étant générées par l'échelle de résistance tandis que la tension V0 est délivrée par la masse du dispositif de conversion. Chaque point milieu peut être relié à tous les autres par une même droite D. On dit ainsi que la caractéristique de transfert d'un dispositif de conversion idéal est linéaire. Dans les dispositifs de conversion réels, des écarts peuvent se produire par rapport à cette linéarité. Un tel écart est représenté en pointillés sur la figure. A ce point de la caractéristique de transfert, le dispositif de conversion réel présente une non-linéarité différentielle DNL différente de zéro, et ladite caractéristique présente un code manquant, en l'occurrence le code 100, ce qui représente une erreur de conversion, puisqu'une même valeur du signal de sortie OUT, en l'occurrence 011, résulte de la conversion de deux valeurs différentes, ici V3 et V4, du signal d'entrée Vin. On voit ainsi que la non-linéarité différentielle DNL est représentative du comportement du dispositif de conversion. Pour que ce comportement soit prédictible, la non-linéarité différentielle DNL doit rester constante quelles que soient les conditions d'utilisation du dispositif de conversion, et en particulier quelle que soit la valeur de son gain, ainsi qu'expliqué plus haut. Ceci est obtenu dans le dispositif de conversion conforme à l'invention décrit à la figure précédente.

La figure 3 représente l'un des amplificateurs A inclus dans un mode de réalisation particulier de l'invention. Chacun de ces amplificateurs A est constitué par deux transistors (T1, T2), dont les bases sont respectivement destinés à recevoir le signal d'entrée analogique Vin et l'une des tensions de référence Vj (pour j=1 à k), lesdits transistors formant une paire différentielle polarisée au moyen d'une source de courant I2, destinée à débiter un courant dont la valeur est proportionnelle à la valeur du signal de contrôle GC. Le signal de sortie de cet amplificateur A peut être prélevé sur le collecteur de l'un des deux transistors (T1, T2), si l'on souhaite disposer d'un signal asymétrique, ou entre les collecteurs desdits transistors (T1, T2) si l'on souhaite disposer d'un signal différentiel.

Dans ce mode de réalisation particulier de l'invention, le signal de contrôle GC agit sur des éléments de même nature, en l'occurrence la première source de courant I1 et les sources de courant I2 des amplificateurs. Le signal de contrôle GC peut donc être exploité au sein des amplificateurs A sans subir de transformation particulière.

Bien qu'il soit envisageable de construire les amplificateurs A sous la forme de cellules de Gilbert, ou plus généralement de multiplicateurs de tension, un tel mode de réalisation serait moins avantageux, car il nécessiterait une conversion en une tension analogique du signal de contrôle GC, et au moins deux paires différentielles supplémentaires pour chaque amplificateur A, destinées à multiplier le signal de sortie de la première paire différentielle (T1, T2) avec le résultat de cette conversion du signal de contrôle GC.

La figure 4 représente un mode de réalisation de la première source de courant I1. Le signal de contrôle GC étant un signal numérique codé sur P bits (GC(0)...GC(P-1), la première source de courant I1 comporte P sources de courant (I10...I1P-1), chacune activée au moyen d'un interrupteur commandé par l'un des bits du signal de contrôle GC. Les P sources de courant (I10...I1P-1) peuvent être construites de manière à toutes débiter un même courant nominal I0. Dans une variante de ce mode de réalisation, on pourra choisir d'attribuer aux courants débités par ces sources des valeurs pondérées: $I1i=2^i.I0$ , pour i=0 à P-1. Ceci permettra d'attribuer des poids différents aux différents bits du signal de contrôle GC. L'utilisation de structures similaires à celle décrite ci-dessus pour réaliser les sources de courant destinées à polariser les paires différentielles constituant les amplificateurs A décrites à la figure précédente permet d'obtenir de manière simple et peu coûteuse une proportionnalité entre le gain GADC du dispositif de conversion et le gain GA des amplificateurs, et donc une non-linéarité différentielle constante, quelles que soient les variations du gain GADC du dispositif de conversion.

**Revendications**

1. Dispositif de conversion destiné à convertir un signal d'entrée analogique en un signal de sortie numérique, présentant un gain défini comme étant égal au rapport entre les valeurs des signaux de sortie et d'entrée, dispositif comprenant :

   . une échelle de résistances, disposées en série entre deux bornes d'alimentation, destinée à générer des tensions de référence,
   . une pluralité d'amplificateurs, chacun étant destiné à délivrer un signal de sortie résultant de l'amplification d'une différence entre le signal d'entrée analogique et l'une des tensions de référence,
   . un étage de détection destiné à signaler des passages par zéro de chacun des signaux de sortie desdits amplificateurs, et
   . un encodeur binaire destiné à délivrer le signal de sortie, dont la valeur dépend desdits passages par zéro,
   dispositif caractérisé en ce qu'il est muni de moyens de réglage pour rendre le gain des amplificateurs et le gain du dispositif de conversion proportionnels entre eux.

2. Dispositif de conversion selon la revendication 1, caractérisé en ce que :

   . les moyens de réglage comprennent une première source de courant, disposée en série avec l'échelle de résistances, et destinée à débiter un courant dont la valeur est proportionnelle à la valeur d'un signai de contrôle, et en ce que
   . chaque amplificateur est muni d'une entrée de réglage, destinée à recevoir le signal de contrôle, le gain de chaque amplificateur étant proportionnel à la valeur du signal reçu sur son entrée de réglage.

3. Dispositif de conversion selon la revendication 2, caractérisé en ce que les amplificateurs sont constitués par des paires différentielles, toutes polarisées au moyen de sources de courants identiques entre elles, chacune étant destinée à débiter un courant dont la valeur est proportionnelle à la valeur du signal de contrôle.

4. Dispositif de conversion selon la revendication 2, caractérisé en ce que les moyens de réglage comprennent en outre un comparateur destiné à opérer, lorsque le signal d'entrée prend une valeur dite de calibration, une comparaison entre la valeur du signal de sortie et une valeur prédéterminée, et à délivrer le signal de contrôle, dont la valeur dépend du résultat de ladite comparaison.

FIG.1

EP 1 039 643 A1

OUT

111
110
101
100
011
010
001
000

V0 V1 V2 V3 V4 V5 V6 V7

Vin

D

FIG.2

DNL ≠ 0

<u>A</u>

T1          T2

Vin ⊘          ⊘ Vj

FIG.3

I2

P

GC

<u>I1</u> ⊘

GC(P-1)

GC(P-2)

GC(0)

I1P-1    I1P-2          I10

FIG.4

Office européen
des brevets

**RAPPORT DE RECHERCHE EUROPEENNE**

Numéro de la demande

EP 00 20 0944

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A,D | GRITFT VAN DE R E J ET AL: "AN 8-BIT VIDEO ADC INCORPORATING FOLDING AND INTERPOLATION TECHNIQUES" IEEE JOURNAL OF SOLID-STATE CIRCUITS,US,IEEE INC. NEW YORK, vol. 22, no. 6, 12 janvier 1987 (1987-01-12), page 944-953 XP000560513 ISSN: 0018-9200 * figure 5 * | 1 | H03M1/10 //H03M1/36 |
| A | EP 0 866 562 A (KONINKL PHILIPS ELECTRONICS NV) 23 septembre 1998 (1998-09-23) * abrégé; figure 1 * | 1 | |

| | DOMAINES TECHNIQUES RECHERCHES (Int.Cl.7) |
|---|---|
| | H03M |

Le présent rapport a été établi pour toutes les revendications

| Lieu de la recherche | Date d'achèvement de la recherche | Examinateur |
|---|---|---|
| LA HAYE | 18 avril 2000 | Beindorff, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

## ANNEXE AU RAPPORT DE RECHERCHE EUROPEENNE
## RELATIF A LA DEMANDE DE BREVET EUROPEEN NO.

EP 00 20 0944

La présente annexe indique les membres de la famille de brevets relatifs aux documents brevets cités dans le rapport de recherche européenne visé ci–dessus.
Lesdits members sont contenus au fichier informatique de l'Officeeuropéen des brevets à la date du
Les renseignements fournis sont donnés à titre indicatif et n'engagent pas la responsabilité de l'Office européen des brevets.

18-04-2000

| Document brevet cité au rapport de recherche | Date de publication | Membre(s) de la famille de brevet(s) | Date de publication |
|---|---|---|---|
| EP 0866562 A | 23-09-1998 | JP 10276089 A | 13-10-1998 |

Pour tout renseignement concernant cette annexe : voir Journal Officiel de l'Office européen des brevets, No.12/82